# FASCICULE DE BREVET EUROPEEN

(11) **EP 4 479 575 B1**
(45) Date de publication et mention de la délivrance du brevet: **24.12.2025**
(21) Numéro de dépôt: 23708849.7
(22) Date de dépôt: 16.02.2023
(51) Int. Cl.: C23C 16/04, C23C 16/44, C23C 16/455, C23C 16/458, F16D 65/12, C04B 35/565, C04B 35/80, C04B 35/83, F16D 69/02

(54) **PROCEDE DE DENSIFICATION PAR INFILTRATION CHIMIQUE EN PHASE GAZEUSE AVEC DES PLATEAUX MONOPILES POUR UN FLUX SEMI-FORCE**
VERDICHTUNGSVERFAHREN DURCH CHEMISCHE DAMPFINFILTRATION UNTER VERWENDUNG VON MONOPILE-PLATTEN FÜR EINEN HALBERZWUNGENEN FLUSS
CHEMICAL VAPOUR INFILTRATION DENSIFICATION METHOD USING MONOPILE PLATES FOR A SEMI-FORCED FLOW

(30) Priorité: 16.02.2022 FR 2201361
(43) Date de publication de la demande: 25.12.2024
(73) Titulaire: Safran Landing Systems, 78140 Vélizy-Villacoublay (FR); Safran Ceramics, 33185 Le Haillan (FR)
(72) Inventeur: CHAMPAGNE, Matthieu, 77550 MOISSY-CRAMAYEL (FR); ROUSTAND, Jeff, 77550 MOISSY-CRAMAYEL (FR); LAMOUROUX, Franck, 77550 MOISSY-CRAMAYEL (FR); BERTRAND, Sébastien, 77550 MOISSY-CRAMAYEL (FR)
(74) Mandataire: Cabinet Beau de Loménie
(86) Numéro de dépôt international: PCT/FR2023/050209
(87) Numéro de publication internationale: WO 2023/156740

(56) Documents cités:
- FR-A1- 3 084 892
- US-A1- 2003 118 728
- US-A1- 2021 285 098
- US-B1- 7 892 646

## Description

### Domaine Technique

L'invention concerne la réalisation de pièces en matériau composite comprenant un substrat annulaire poreux densifié par infiltration chimique en phase gazeuse (CVI), et plus particulièrement la réalisation de pièces munies d'un passage central. L'invention est applicable notamment, mais non exclusivement à la réalisation de disques de frein annulaires ou de divergents de tuyères de moteurs de fusée en matériau composite thermostructural.

### Technique antérieure

Les matériaux composites thermostructuraux sont remarquables par leurs propriétés mécaniques élevées et leur capacité à conserver ces propriétés à haute température. Des exemples typiques de matériaux composites thermostructuraux sont les composites carbone-carbone (C-C) comprenant un substrat poreux de renfort en fibres de carbone densifié par une matrice en carbone et les composites à matrice céramique (CMC) comprenant un substrat poreux de renfort en fibres réfractaires (par exemple en carbone ou céramique) densifié par une matrice céramique (par exemple en carbure de silicium).

Les matériaux composites C-C sont communément utilisés pour la réalisation de disques de frein d'aéronefs, cela en raison de leurs caractéristiques tribologiques à hautes énergies, leur non-fragilité, leurs caractéristiques thermiques (conductivité et capacité calorique) et leur densité.

La densification de substrats poreux par infiltration chimique en phase vapeur (CVI) consiste à placer les préformes annulaires dans une chambre de réaction d'une installation d'infiltration et à admettre dans la chambre une phase gazeuse dont un ou plusieurs constituants forment un précurseur du matériau de la matrice à déposer au sein des substrats afin d'assurer leur densification. Les conditions d'infiltration, notamment la composition et le débit de la phase gazeuse, et la température et la pression dans la chambre, sont choisies pour permettre une diffusion de la phase gazeuse au sein de la porosité interne accessible des substrats afin que le matériau désiré y soit déposé par décomposition d'un constituant de la phase gazeuse ou par réaction entre plusieurs constituants de celle-ci. Le document FR 2 834 713 décrit un tel procédé et une installation pour sa mise en œuvre.

Les conditions d'infiltration chimique en phase vapeur du Carbone pyrolytique, ou pyrocarbone, sont connues depuis longtemps de l'homme de l'art. Le précurseur du carbone est un alcane, un alkyle ou un alcène, généralement du propane, du méthane ou un mélange des deux. L'infiltration est réalisée à une température d'environ 1000°C sous une pression par exemple d'erviron 1 kPa.

La phase gazeuse contenant le ou les précurseurs de matériau à déposer au sein des préformes est admise à une extrémité longitudinale de l'enceinte réactionnelle, tandis que les gaz résiduels sont évacués à l'extrémité opposée d'où ils sont extraits par des moyens de pompage.

Les réacteurs prévus pour la réalisation d'études en recherche et développement en infiltration des disques de frein ont une configuration de chargement classiquement constituée d'un empilement de plateaux portant chacun une seule pile de disques. On parle de fours « monopiles ». Cette configuration diffère des chargements industriels, réalisés dans des réacteurs de plus grande taille, dans lesquels les plateaux portent plusieurs piles de disques côte à côte, et pour lesquels on parle de fours « multipiles ».

Dans les deux cas, les disques sont séparés par des supports intermédiaires appelés cales, et les plateaux comprennent des ouvertures alignées avec des passages centraux des disques afin de faire circuler dans chaque pile une phase gazeuse réactive qui traversera ensuite les disques pour les densifier. Un plateau supérieur surmonte le chargement et ferme le volume interne de chaque pile. Les plateaux supportant les piles de disques sont maintenus à l'aide de chandelles verticales.

Le procédé de densification classique, utilisé industriellement et applicable dans le four utilisé en recherche et développement, est le flux dirigé.

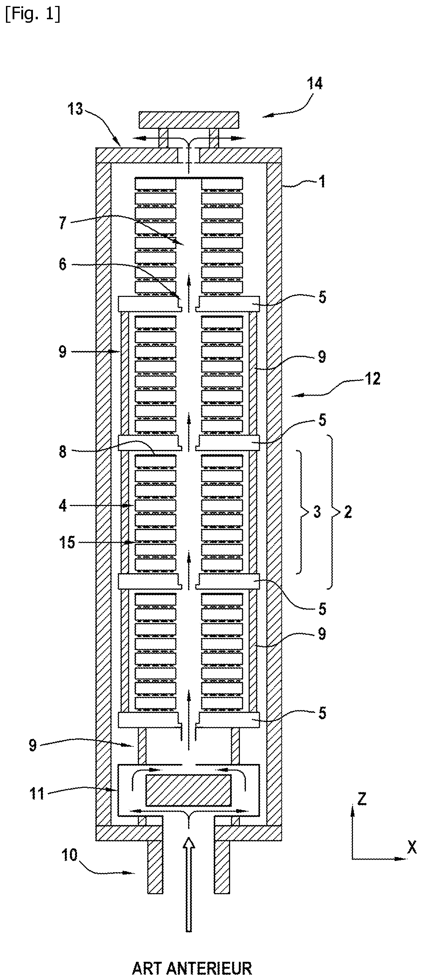

Un exemple connu de chargement monopile de disques pouvant être utilisé dans une enceinte réactionnelle appelée communément « four de densification » est illustré sur la figure 1.

L'enceinte 1 possède une symétrie cylindrique autour d'un axe Z. Le chargement comprend une pile de modules unitaires 2, chaque module unitaire 2 comprenant un unique empilement 3 de substrats annulaires poreux 4 porté par un plateau support inférieur 5. Les plateaux 5 comprennent des ouvertures 6 alignées avec des passages centraux 7 des substrats 4 afin de faire circuler, dans chaque empilement 3, une phase gazeuse réactive qui traversera ensuite les substrats 4 pour les densifier. Chaque empilement 3 est surmonté d'un disque de couverture 8 annulaire et chaque module unitaire 2 comprend en outre des chandelles verticales 9 s'étendant entre le plateau support 5 du module unitaire 2 et le plateau support 5 du module unitaire 2 au-dessus. Les chandelles verticales 9 servent à reprendre la masse des plateaux supports 5 supérieurs et permettent ainsi d'assurer le maintien des plateaux supports 5.

La figure 1 est une représentation de la zone chaude d'un chargement en flux dirigé. Cette zone chaude comprend, depuis sa base jusqu'à son sommet : une arrivée du mélange gazeux réactionnel 10, puis une zone de préchauffage 11 qui permet d'accroitre la température des gaz jusqu'à la température de densification, et enfin la zone de chargement 12. En haut du four, au niveau du couvercle suscepteur 13, une cheminée 14 est installée dans le couvercle 13, par laquelle les gaz effluents issus de la réaction de dépôt sont évacués.

Sur chaque plateau 5 se trouve un empilement de substrats 4 séparés par des cales 15, chaque empilement se terminant à son sommet par un disque de couverture 8 qui limite les fuites.

Les gaz à l'issue de la zone de préchauffage 11 entrent dans chacune des colonnes constituées par les empilements 3 de substrats 4. Le gaz passe de l'intérieur à l'extérieur des colonnes de substrats 4, par les fuites constituées par les porosités de chaque préforme 4, le jeu entre les substrats 4 créé par les cales 15, et par les passages entre les plateaux 5.

Il est connu du document FR 2 821 859 un procédé de densification par infiltration chimique en phase vapeur de substrats poreux utilisant notamment un flux semi forcé. Pour adapter le flux semi forcé tel que décrit dans ce document, les fuites entre les substrats doivent être contrôlées et les fuites au passage entre plateaux doivent être contrôlées également. Autrement dit, la maîtrise des fuites autres que celles liées aux porosités des préformes 4 permet d'améliorer la cinétique de densification : c'est la mise en œuvre du procédé dit de « flux semi forcé ».

La mise en œuvre du flux semi forcé consiste à prévoir des passages de fuites calibrés entre l'intérieur et l'extérieur des colonnes de substrats, ce qui implique de rendre étanche des zones laissées libres dans la mise en œuvre du procédé actuel de flux dirigé : ces zones se trouvent en particulier au niveau des cales inter-disques et de la jonction entre l'empilement inférieur et le plateau support du module unitaire supérieur.

Un gradient de pression va s'établir et augmenter au fur et à mesure de la densification des préformes entre l'intérieur (où arrive le gaz) et l'extérieur des empilements. La mise en place des fuites calibrées doit permettre de plafonner ce gradient de pression afin d'éviter des dépôts de suies à l'intérieur de l'empilement de substrats à cause d'une pression trop élevée. Le suivi de ce gradient de pression, qui témoigne de l'avancement de la densification, est donc nécessaire pour la conduite du cycle.

Les fuites au passage entre plateaux sont les plus difficiles à contrôler car les empilements de substrats annulaires poreux ne sont pas de même hauteur. Et en l'absence d'un excellent contrôle de cette étanchéité au sommet de chaque empilement, la différence de pression nécessaire pour forcer le gaz à aller dans les porosités des substrats 2 ne peut pas être obtenue.

Il est également connu du brevet FR 3 084 892 de remplacer les chandelles par des distributeurs de gaz, qui permettent d'assurer simultanément les fonctions de reprise de la charge (fonction auparavant faite par les chandelles), de guidage des gaz (froids), ce qui évite le refroidissement des disques, et de distribution des gaz au niveau des préformes.

Un procédé de densification par CVI à gradient de pression de substrats annulaires poreux présentant un passage central est également connu du document US 7 892 646 B1.

### Exposé de l'invention

L'invention a pour but de fournir une solution technique pour la mise en œuvre d'un procédé de densification qui permet d'améliorer la distribution du gaz réactif à l'intérieur d'une zone de chargement d'un four de densification et, d'une façon générale, de réduire les gradients de densification entre les substrats situés en des emplacements différents de la zone de chargement, et ce sans affecter la capacité de chargement du four, voire même en l'augmentant.

Un objet de l'invention propose un procédé de densification par infiltration chimique en phase gazeuse à gradient de pression de substrats annulaires poreux présentant un passage central, tel que défini dans les revendications 1-13.

Selon une caractéristique générale de l'invention, dans chaque module unitaire, chaque premier substrat annulaire poreux est en appui sur un deuxième substrat annulaire poreux, ou en appui sur le plateau support, par l'intermédiaire d'un anneau d'étanchéité assurant l'étanchéité radiale entre le premier substrat annulaire poreux et le deuxième substrat annulaire poreux ou entre le premier substrat annulaire poreux et ledit plateau support.

Autrement dit, chaque module unitaire comprend une pluralité d'anneaux d'étanchéité, chaque anneau d'étanchéité étant disposé en appui entre deux substrats annulaires poreux successifs ou entre un substrat annulaire poreux et le plateau support.

Par "étanchéité radiale", on entend l'étanchéité empêchant la circulation de la phase gazeuse selon une direction radiale entre le volume interne des empilements et l'extérieur des empilements.

L'invention permet ainsi de mieux contrôler la circulation du gaz autour des substrats annulaires poreux et donc d'améliorer la répartition du gaz dans l'enceinte du four.

En outre, dans chaque module unitaire, chaque anneau d'étanchéité est couplé à une cale annulaire présentant un diamètre interne égal à un diamètre interne des substrats annulaires poreux.

Les cales annulaires permettent de centrer les anneaux d'étanchéité et donc de faciliter leur positionnement.

Chaque cale annulaire présente une épaisseur inférieure à l'épaisseur de l'anneau d'étanchéité auquel elle est couplée. Ce rapport d'épaisseur a pour avantage d'assurer un appui du substrat annulaire poreux sur l'anneau d'étanchéité. L'étanchéité radiale est ainsi assurée. En outre, ce rapport d'épaisseur offre l'avantage de laisser une libre circulation de la phase gazeuse autour des substrats annulaires poreux.

Dans un exemple de réalisation, chaque empilement comprend au moins un disque de couverture en appui sur le substrat annulaire poreux au sommet de l'empilement par l'intermédiaire d'un anneau d'étanchéité assurant l'étanchéité radiale entre ledit disque de couverture et ledit substrat annulaire poreux au sommet de l'empilement.

Chaque empilement peut également comprendre un joint annulaire déformable agencé pour être comprimé entre le disque de couverture et le plateau support du module unitaire supérieur.

Le joint annulaire déformable est par exemple en feutre de fibres de carbone.

De plus, chaque empilement peut également comprendre un disque en graphite expansé disposé entre le joint annulaire déformable et le plateau support du module unitaire supérieur. Le disque en graphite expansé permet d'éviter que le joint annulaire déformable ne soit collé au plateau support au-dessus.

Selon une première forme de réalisation, dans chaque module unitaire, les anneaux d'étanchéité sont disposés au niveau de la périphérie radialement externe des substrats annulaires poreux.

Selon une deuxième forme de réalisation, dans chaque module unitaire, les anneaux d'étanchéité sont alternativement disposés, selon la direction dans laquelle sont empilés les substrats annulaires poreux, au niveau de la périphérie radialement externe des substrats annulaires poreux et au niveau de la périphérie radialement interne des substrats annulaires poreux.

Ces deux formes de réalisation permettent de maximiser les surfaces de contact des substrats annulaires poreux avec la phase gazeuse.

Les anneaux d'étanchéité sont par exemple en Inconel^{®}.

Les cales annulaires peuvent également être en Inconel^{®}.

Chaque anneau d'étanchéité est par exemple soudé à la calle annulaire à laquelle il est couplé. Ce soudage permet de faciliter la formation des empilements.

Selon une forme particulière de réalisation, le procédé comprend en outre une pose d'un couvercle massif au sommet de la pile de modules unitaires. Ce couvercle massif permet de comprimer les éléments déformables, notamment les anneaux d'étanchéité et les joints annulaires déformables.

Selon une forme particulière de réalisation, le procédé comprend en outre une étape d'alignement étanche des modules unitaires de la pile comportant, pour chaque premier module unitaire empilé sur un second module unitaire, une insertion de la deuxième extrémité du tube d'injection du second module unitaire dans l'ouverture d'admission de gaz du premier module unitaire empilé sur ledit second module unitaire, un joint annulaire étant disposé entre la deuxième extrémité du tube d'injection du second module unitaire et l'ouverture d'admission de gaz du premier module unitaire empilé sur ledit second module unitaire.

Dans un exemple de réalisation, pour chaque module unitaire, le plateau support peut comprendre une première face sur laquelle est disposé l'empilement du module unitaire et une seconde face opposée à la première face, l'ouverture d'admission de gaz peut comprendre une forme tronconique avec un premier diamètre formé dans la seconde face du support et un second diamètre plus petit que le premier diamètre et formé dans la première face ou entre la première et la seconde face du plateau support, et la deuxième extrémité du tube d'injection peut comprendre une forme tronconique complémentaire coopérant avec la forme tronconique de l'ouverture d'admission de gaz.

Le tube d'injection forme ainsi un outil de centrage mâle et l'ouverture d'admission de gaz un outil de centrage femelle coopérant ensemble pour assurer un bon centrage des modules unitaires les uns avec les autres.

De préférence, chaque plateau support peut comprendre, sur sa première face, un anneau de centrage centré autour d'une ouverture de gaz et conformé pour accueillir un tube d'injection.

L'anneau de centrage permet ainsi de faciliter et d'optimiser la pose des tubes d'injection sur les plateaux support.

Dans un exemple de mise en œuvre du procédé, le procédé peut comprendre en outre une étape de disposition de la pile de modules unitaires sur une virole porte charge disposée sur une zone de préchauffage du four de densification.

Dans un exemple de réalisation, chaque module unitaire peut comprendre un pied annulaire disposé entre le plateau support du module unitaire et l'empilement de substrats annulaires poreux du module unitaire, le pied annulaire comportant des rainures radiales formant des passages, selon une direction orthogonale à la direction dans laquelle sont empilés les substrats annulaires poreux entre une cavité centrale du pied annulaire et l'extérieur du pied annulaire.

Selon une forme particulière de réalisation, l'étape d'injection d'une phase gazeuse dans le volume interne de chaque empilement comprend un maintien d'une différence de pression entre le volume interne des empilements et l'extérieur des empilements comprise entre 0 et 100 millibars.

Dans un exemple de réalisation, chaque substrat annulaire poreux peut comprendre du carbone.

Dans un exemple de réalisation, chaque substrat annulaire poreux peut constituer une préforme fibreuse de disque de frein.

### Brève description des dessins

[Fig. 1] La figure 1, déjà décrite, montre de façon très schématique un exemple de chargement de substrats annulaires poreux selon l'art antérieur.
[Fig. 2] La figure 2 illustre schématiquement une vue en coupe d'un exemple d'empilement de substrats annulaires poreux selon l'invention.
[Fig. 3] La figure 3 présente schématiquement une vue en coupe d'un four de densification selon l'invention.
[Fig. 4] La figure 4 présente schématiquement une vue de dessus d'un pied annulaire.
[Fig. 5] La figure 5 présente schématiquement une vue en coupe d'un pied annulaire.

### Description des modes de réalisation

Un procédé de densification par infiltration chimique en phase gazeuse selon l'invention comprend tout d'abord une étape durant laquelle on fournit une pluralité d'empilement de substrats annulaires poreux destinés à être traités par infiltration chimique en phase gazeuse.

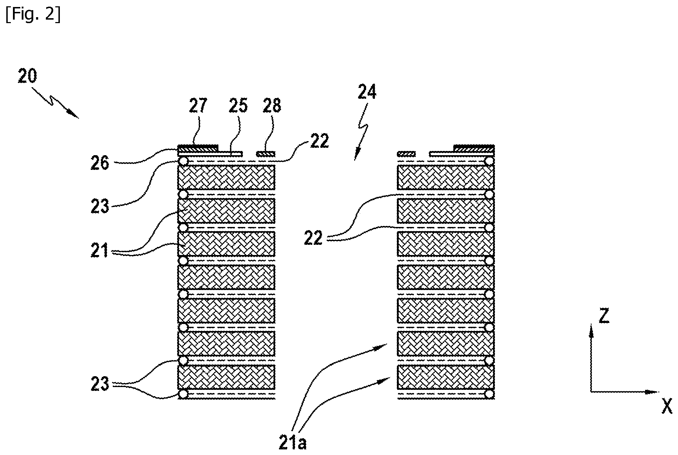

Sur la figure 2 est illustrée une vue en coupe d'un exemple d'empilement 20 de substrats annulaires poreux 21. Les substrats annulaires poreux 21 possèdent une symétrie cylindrique et sont empilés selon une première direction Z. Chaque substrat annulaire poreux 21 s'étend principalement dans un plan perpendiculaire à la première direction Z. Le plan de coupe de l'illustration de la figure 2 comprend la première direction Z et une seconde direction X perpendiculaire à la première direction Z. La première direction Z est confondue avec l'axe de symétrie de révolution des substrats annulaires poreux 21, et la seconde direction X correspond à une direction radiale.

Chaque substrat annulaire poreux 21 de l'empilement 20 présente ainsi une forme d'anneau avec un passage central 21a. Chaque substrat annulaire poreux 21 est disposé sur un ensemble comprenant une cale annulaire 22 et un anneau d'étanchéité 23. Le diamètre radial extérieur de la cale annulaire 22 est plus petit que le diamètre radial extérieur des substrats annulaires poreux 21, les diamètres des orifices des cales annulaires 22 et des substrats annulaires poreux 21 étant égaux.

Chaque cale annulaire 22 est entourée d'un anneau d'étanchéité 23 dans le plan perpendiculaire à la première direction Z. L'épaisseur de l'anneau d'étanchéité 23 mesurée selon la première direction Z est supérieure à celle de la cale annulaire 22, de sorte que chaque substrat annulaire poreux 21 repose sur un anneau d'étanchéité 23. Les cales annulaires 23 permettent de centrer les anneaux d'étanchéité 23sur la première direction Z.

L'empilement alternatif des substrats annulaires poreux 21 et des anneaux d'étanchéité 23 forme, au centre de l'empilement 20, un volume interne 24 de l'empilement 20.

En outre, l'empilement 20 est fermé en son sommet par un disque de couverture 25 annulaire. Le disque de couverture 25 est posé sur l'empilement via une cale annulaire 22 et un anneau d'étanchéité 23. L'empilement comprend également un joint annulaire déformable 26 en feutre comprimé de fibres de carbone disposé sur le disque de couverture 25, et un disque 27 en graphite expansé disposé sur le joint annulaire déformable 26 pour éviter que ce joint annulaire déformable 26 ne soit collé au plateau support au-dessus.

L'empilement 20 comprend également un anneau d'étanchéité secondaire 28 annulaire également en feutre comprimé de fibres de carbone directement sur la cale annulaire 22 supportant le disque de couverture 25. L'anneau d'étanchéité secondaire 28 couvre la partie de la cale annulaire 22 non couverte par le disque de couverture 25.

Le procédé de densification par infiltration chimique en phase gazeuse selon l'invention comprend ensuite une étape durant laquelle on fournit une pluralité de modules unitaires 30.

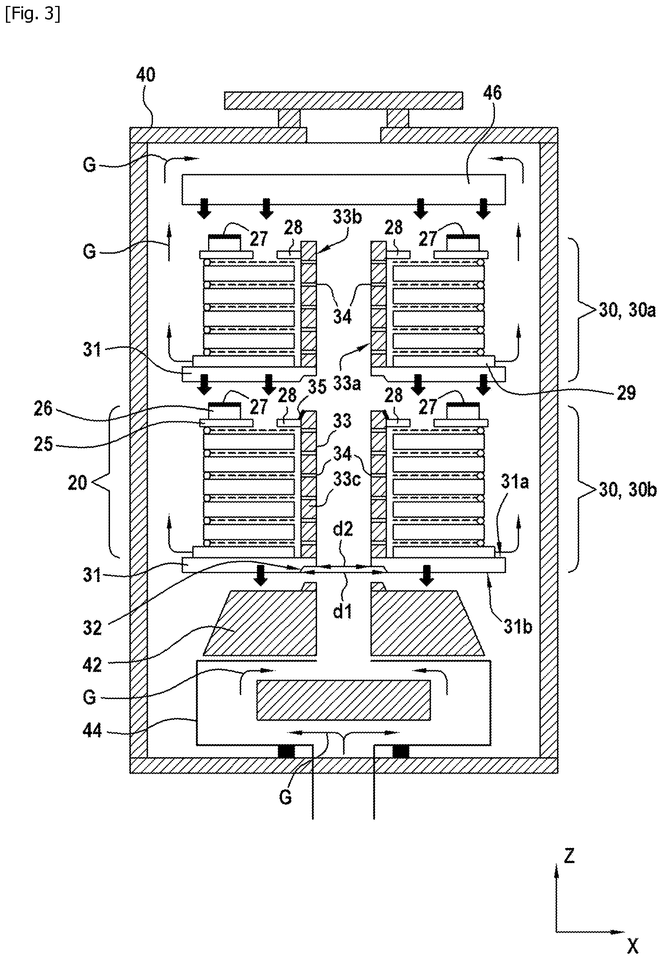

Sur la figure 3 est représentée schématiquement une vue en coupe d'un four de densification selon l'invention.

Le four de densification 40 selon l'invention comprend une pile d'une pluralité de modules unitaires 30. Chaque module unitaire 30 comprend un plateau support 31 sur lequel est disposé un empilement 20 de substrats annulaires poreux via un pied 29 annulaire, le pied 29 annulaire étant disposé entre le plateau support 31 et l'empilement 20 d'un même module unitaire 30.

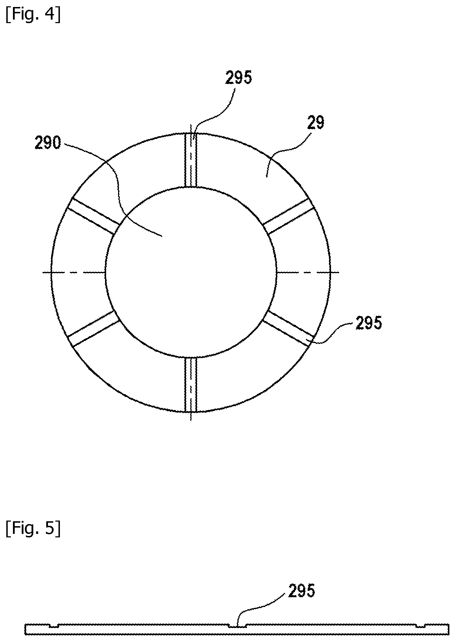

Comme cela est représenté sur les figures 4 et 5 qui présentent une vue de dessus et une vue en coupe d'un pied annulaire 29, le pied annulaire 29 comporte des rainures radiales 295 formant des passages, selon une direction radiale, entre une cavité centrale 290 du pied annulaire 29 et l'extérieur du pied annulaire 29.

Comme cela est illustré sur la figure 3, le plateau support 31 d'un module unitaire 30 comporte une ouverture 32 d'admission de gaz et un tube d'injection 33 monté sur l'ouverture 32 d'admission de gaz et s'étendant dans le volume interne 24 de l'empilement 20 entre une première extrémité de tube 33a reliée au plateau support 31 et une deuxième extrémité de tube 33b qui est libre.

Le tube d'injection 33 comprend en outre des orifices 34 d'injection de gaz débouchant dans le volume interne 24.

Le procédé de densification par infiltration chimique en phase gazeuse selon l'invention comprend ensuite une étape durant laquelle on forme, dans l'enceinte d'un four de densification 40, une pile de modules unitaires 30.

Sur la figure 3 est représenté le plateau support 31 d'un premier module unitaire 30a sur le point d'être superposé sur un second module unitaire 30b.

L'étape de formation de la pile de modules unitaires 30 comprend en outre une étape d'alignement étanche des modules unitaires 30 de la pile. Comme cela est illustré sur la figure 3, pour réaliser l'alignement, la deuxième extrémité 33b du tube d'injection 33 du second module unitaire 30b est insérée dans l'ouverture 32 d'admission de gaz du premier module unitaire 30a.

Pour étanchéifier la jonction entre le tube d'injection 33 du second module unitaire 30b et l'ouverture 32 d'admission de gaz du premier module unitaire 30a, le second module unitaire 30a comporte en outre un joint annulaire 35 disposé entre la deuxième extrémité 33b du tube d'injection 33 du second module unitaire 30b et l'ouverture 32 d'admission de gaz du premier module unitaire 30a.

Plus particulièrement, chaque plateau support 31 comprend une première face 31a sur laquelle est disposé l'empilement 20 et une seconde face 31b opposée à la première face 31a. L'ouverture 32 d'admission de gaz comprend une forme tronconique avec un premier diamètre d1 formé dans la seconde face 31b du plateau support 31 et un second diamètre d2 plus petit que le premier diamètre d2 et formé entre la première face 31a et la seconde face 31b du plateau support 31.

La deuxième extrémité 33b de chaque tube d'injection 33 comprend une forme tronconique complémentaire de la forme tronconique d'une ouverture 32 d'admission de gaz pour que les deux formes tronconiques coopèrent ensemble. La forme tronconique complémentaire de la deuxième extrémité 33b du tube d'injection 33 comprend un troisième diamètre plus grand qu'un quatrième diamètre, le quatrième diamètre étant mesuré sur une extrémité distale libre tandis que le premier diamètre est mesuré sur une extrémité proximale couplée au reste du tube d'injection 33 et notamment à une portion principale 33c.

Comme cela est illustré sur la figure 3, pour améliorer l'étanchéité de la pile de modules unitaires 30, le joint annulaire déformable 26 est dimensionné pour combler l'espace, selon la première direction Z, entre le disque de couverture 25 de l'empilement 20 du second module unitaire 30b et le plateau support 31 du premier module unitaire 30a.

Le procédé de densification par infiltration chimique en phase gazeuse selon l'invention comprend ensuite une étape de disposition de la pile de modules unitaires 30 sur une virole porte charge 42 disposée sur une zone de préchauffage 44 du four de densification 40.

Le procédé de densification par infiltration chimique en phase gazeuse selon l'invention comprend ensuite une pose d'un couvercle massif 46 au sommet de la pile de modules unitaires 30.

Le procédé de densification par infiltration chimique en phase gazeuse selon l'invention comprend ensuite une étape durant laquelle on injecte dans le volume interne 24 de chaque empilement 20 de substrats annulaires poreux 21 une phase gazeuse comprenant un précurseur gazeux d'un matériau de matrice à déposer au sein de la porosité des substrats 21. L'injection du gaz est représentée sur la figure 3 par les flèches G. L'étape d'injection d'une phase gazeuse dans le volume interne 24 des empilements 20 comprend de préférence une régulation de la différence de pression entre le volume interne 24 des empilements 20 et l'extérieur des empilements. La différence de pression est de préférence maintenue entre 0 et 100 millibars. Une telle plage permet d'assurer un flux de la phase gazeuse autour des substrats annulaires poreux 21 tout en évitant le dépôt de suies.

## Revendications

1. Procédé de densification par infiltration chimique en phase gazeuse à gradient de pression de substrats annulaires poreux (21) présentant un passage central (21a), le procédé comprenant au moins les étapes suivantes :
- fournir une pluralité d'empilements (20) de substrats annulaires poreux (21), chaque empilement (20) comportant un volume interne (24) formé par les passages centraux (21a) des substrats (21) empilés,
- fournir une pluralité de modules unitaires (30), chaque module unitaire (30) comprenant un plateau support (31) et un unique empilement (20) de substrats annulaires poreux (21) disposé sur le plateau support (31), le plateau support (31) comportant une ouverture d'admission de gaz (32) et un tube d'injection (33) monté sur l'ouverture d'admission de gaz (32) et s'étendant dans le volume interne (24) de l'empilement (20) disposé sur le plateau support (31) entre une première extrémité de tube (33a) reliée au plateau support (31) et une deuxième extrémité de tube (33b) qui est libre, le tube d'injection (33) comprenant en outre des orifices d'injection de gaz (34) débouchant dans le volume interne (24),
- former, dans l'enceinte d'un four de densification (40), une pile de modules unitaires (30), chaque premier module unitaire (30a) empilé sur un second module unitaire (30b) ayant son ouverture d'admission de gaz (32) du plateau support (31) communiquant avec la deuxième extrémité (33b) du tube d'injection (33) du second module unitaire (30b) sur lequel il est empilé de façon à permettre la circulation d'un gaz entre les modules unitaires (30), et
- injecter dans le volume interne (24) de chaque empilement (20) de substrats annulaires poreux (21) une phase gazeuse comprenant un précurseur gazeux d'un matériau de matrice à déposer au sein de la porosité des substrats (21),
**caractérisé en ce que,** dans chaque module unitaire (30), chaque premier substrat annulaire poreux (21) est en appui sur un deuxième substrat annulaire poreux (21), ou en appui sur le plateau support (31), par l'intermédiaire d'un anneau d'étanchéité (23) assurant l'étanchéité radiale entre le premier substrat annulaire poreux (21) et le deuxième substrat annulaire poreux (21) ou entre le premier substrat annulaire poreux (21) et ledit plateau support (31), et
chaque anneau d'étanchéité (23) est couplé à une cale annulaire (22) présentant un diamètre interne égal à un diamètre interne des substrats annulaires poreux (21), chaque cale annulaire (22) étant entourée par l'anneau d'étanchéité (23) auquel elle est associée dans un plan perpendiculaire à la direction dans laquelle sont empilés les substrats annulaires poreux (21), et présentant une épaisseur inférieure à l'épaisseur de l'anneau d'étanchéité (23) auquel elle est couplée.

2. Procédé selon la revendication 1, dans lequel chaque empilement (20) comprend au moins un disque de couverture (25) en appui sur le substrat annulaire poreux (21) au sommet de l'empilement (20) par l'intermédiaire d'un anneau d'étanchéité (23) assurant l'étanchéité radiale entre ledit disque de couverture (25) et ledit substrat annulaire poreux (21) au sommet de l'empilement (20).

3. Procédé selon la revendication 2, dans lequel chaque empilement (20) comprend un joint annulaire déformable (26) agencé pour être comprimé entre le disque de couverture (25) et le plateau support (31) du module unitaire (30) supérieur.

4. Procédé selon l'une des revendications 1 à 3, dans lequel, dans chaque module unitaire (30), les anneaux d'étanchéité (23) sont disposés au niveau de la périphérie radialement externe des substrats annulaires poreux (21).

5. Procédé selon l'une des revendications 1 à 3, dans lequel, dans chaque module unitaire (30), les anneaux d'étanchéité (23) sont alternativement disposés, selon la direction dans laquelle sont empilés les substrats annulaires poreux, au niveau de la périphérie radialement externe des substrats annulaires poreux (21) et au niveau de la périphérie radialement interne des substrats annulaires poreux (21).

6. Procédé selon l'une des revendications 1 à 5, dans lequel les anneaux d'étanchéité (23) sont en Inconel^{®}.

7. Procédé selon l'une des revendications 1 à 6, dans lequel chaque anneau d'étanchéité (23) est soudé à la cale annulaire (22) à laquelle il est couplé.

8. Procédé selon l'une des revendications 1 à 7, comprenant en outre une étape d'alignement étanche des modules unitaires (30) de la pile comportant, pour chaque premier module unitaire (30a) empilé sur un second module unitaire (30b), une insertion de la deuxième extrémité (33b) du tube d'injection (33) du second module unitaire (30b) dans l'ouverture d'admission de gaz (32) du premier module unitaire (30a) empilé sur ledit second module unitaire (30b), un joint annulaire (35) étant disposé entre la deuxième extrémité (33b) du tube d'injection (33) du second module unitaire (30b) et l'ouverture d'admission de gaz (32) du premier module unitaire (30a) empilé sur ledit second module unitaire (30b).

9. Procédé selon la revendication 8, dans lequel, pour chaque module unitaire (30), le plateau support (31) comprend une première face (31a) supportant l'empilement (20) du module unitaire (30) et une seconde face (31b) opposée à la première face (31a), l'ouverture d'admission de gaz (32) comprend une forme tronconique avec un premier diamètre (d1) formé dans la seconde face (31b) du support (31) et un second diamètre (d2) plus petit que le premier diamètre (d1) et formé dans la première face (31a) ou entre la première face (31a) et la seconde face (31b) du plateau support (31), et la deuxième extrémité (33b) du tube d'injection (33) comprend une forme tronconique complémentaire coopérant avec la forme tronconique d'une ouverture d'admission de gaz (32).

10. Procédé selon l'une des revendications 1 à 9, comprenant en outre une étape de disposition de la pile de modules unitaires (30) sur une virole porte charge (42) disposée sur une zone de préchauffage (44) du four de densification (40).

11. Procédé selon l'une des revendications 1 à 10, dans lequel chaque module unitaire (30) comprend un pied (29) annulaire disposé entre le plateau support (31) du module unitaire (30) et l'empilement (20) de substrats annulaires poreux (21) du module unitaire (30), le pied annulaire comportant des rainures radiales formant des passages, selon une direction (X) orthogonal à la direction dans laquelle sont empilés les substrats annulaires poreux entre une cavité centrale du pied annulaire et l'extérieur du pied annulaire.

12. Procédé selon l'une des revendications 1 à 11, dans lequel chaque substrat annulaire poreux (21) comprend du carbone.

13. Procédé selon l'une des revendications 1 à 12, dans lequel chaque substrat annulaire poreux (21) constitue une préforme fibreuse de disque de frein.

## Patentansprüche

1. Verfahren zur Verdichtung von ringförmigen porösen Substraten (21), die einen zentralen Durchgang (21a) aufweisen, durch chemische Druckgradient-Gasphasen-Infiltration, wobei das Verfahren zumindest die folgenden Schritte umfasst:
- Bereitstellen von mehreren Aufstapelungen (20) von ringförmigen porösen Substraten (21), wobei jede Aufstapelung (20) ein Innenvolumen (24) beinhaltet, das durch die zentralen Durchgänge (21a) der gestapelten Substrate (21) gebildet wird,
- Bereitstellen von mehreren Einheitsmodulen (30), wobei jedes Einheitsmodul (30) eine Stützplattform (31) und eine einzige Aufstapelung (20) von ringförmigen porösen Substraten (21) umfasst, die auf der Stützplattform (31) angeordnet sind, wobei die Stützplattform (31) eine Gaseinlassöffnung (32) und ein Injektionsrohr (33) beinhaltet, das an der Gaseinlassöffnung (32) montiert ist und sich in dem Innenvolumen (24) der Aufstapelung (20), die auf der Stützplattform (31) angeordnet ist, zwischen einem ersten Rohrende (33a), das mit der Stützplattform (31) verbunden ist, und einem zweiten Rohrende (33b) erstreckt, das frei liegt, wobei das Injektionsrohr (33) ferner Gas-Injektionsöffnungen (34) umfasst, die in das Innenvolumen (24) münden,
- Bilden eines Stapels von Einheitsmodulen (30) in der Einhausung eines Verdichtungsofens (40), wobei jedes erste Einheitsmodul (30a), das über ein zweites Einheitsmodul (30b) gestapelt ist, seine Gaseinlassöffnung (32) der Stützplattform (31) mit dem zweiten Ende (33b) des Injektionsrohrs (33) des zweiten Einheitsmoduls (30b), über welches es gestapelt ist, auf solche Weise in Kommunikation hat, dass die Zirkulation eines Gases zwischen den Einheitsmodulen (30) ermöglicht wird, und
- Einspritzen in das Innenvolumen (24) einer jeden Aufstapelung (20) von ringförmigen porösen Substraten (21) einer Gasphase umfassend einen gasförmigen Vorläufer eines Matrixmaterials, das innerhalb der Porosität der Substrate (21) abgeschieden werden soll,
**dadurch gekennzeichnet, dass** in jedem Einheitsmodul (30) jedes erste ringförmige poröse Substrat (21) auf einem zweiten ringförmigen porösen Substrat (21), oder auf der Stützplattform (31) mittels eines Dichtungsrings (23) aufliegt, der die radiale Dichtigkeit zwischen dem ersten ringförmigen porösen Substrat (21) und dem zweiten ringförmigen porösen Substrat (21) oder zwischen dem ersten ringförmigen porösen Substrat (21) und der Stützplattform (31) sicherstellt, und
jeder Dichtungsring (23) mit einem ringförmigen Keil (22) gekoppelt ist, der einen Innendurchmesser aufweist, der gleich einem Innendurchmesser der ringförmigen porösen Substrate (21) ist, wobei jeder ringförmige Keil (22) von dem Dichtungsring (23), mit dem er verbunden ist, in einer Ebene senkrecht zu der Richtung, gemäß welcher die ringförmigen porösen Substrate (21) gestapelt sind, umgeben ist und eine Dicke aufweist, die geringer ist als die Dicke des Dichtungsrings (23), mit dem er gekoppelt ist.

2. Verfahren nach Anspruch 1, wobei jede Aufstapelung (20) zumindest eine Abdeckscheibe (25) umfasst, die auf dem ringförmigen porösen Substrat (21) an dem Scheitel der Aufstapelung (20) mittels eines Dichtungsrings (23) aufliegt, der die radiale Dichtigkeit zwischen der Abdeckscheibe (25) und dem ringförmigen porösen Substrat (21) an dem Scheitel der Aufstapelung (20) sicherstellt.

3. Verfahren nach Anspruch 2, wobei jede Aufstapelung (20) eine verformbare ringförmige Dichtung (26) umfasst, die so angeordnet ist, dass sie zwischen der Abdeckscheibe (25) und der Stützplattform (31) des oberen Einheitsmoduls (30) komprimiert wird.

4. Verfahren nach einem der Ansprüche 1 bis 3, wobei in jedem Einheitsmodul (30) die Dichtungsringe (23) an dem radial äußeren Umfang der ringförmigen porösen Substrate (21) angeordnet sind.

5. Verfahren nach einem der Ansprüche 1 bis 3, wobei in jedem Einheitsmodul (30) die Dichtungsringe (23) gemäß der Richtung, in welcher die ringförmigen porösen Substrate gestapelt sind, abwechselnd an dem radial äußeren Umfang der ringförmigen porösen Substrate (21) und an dem radial inneren Umfang der ringförmigen porösen Substrate (21) angeordnet sind.

6. Verfahren nach einem der Ansprüche 1 bis 5, wobei die Dichtungsringe (23) aus Inconel^{®} bestehen.

7. Verfahren nach einem der Ansprüche 1 bis 6, wobei jeder Dichtungsring (23) an den ringförmigen Keil (22), mit dem er gekoppelt ist, angeschweißt ist.

8. Verfahren nach einem der Ansprüche 1 bis 7, umfassend ferner einen Schritt der dichten Ausrichtung von Einheitsmodulen (30) des Stapels, der für jedes erste Einheitsmodul (30a), das über ein zweites Einheitsmodul (30b) gestapelt ist, eine Einführung des zweiten Endes (33b) des Injektionsrohrs (33) des zweiten Einheitsmoduls (30b) in die Gaseinlassöffnung (32) des ersten Einheitsmoduls (30a), das über das zweite Einheitsmodul (30b) gestapelt ist, beinhaltet, wobei eine ringförmige Dichtung (35) zwischen dem zweiten Ende (33b) des Injektionsrohrs (33) des zweiten Einheitsmoduls (30b) und der Gaseinlassöffnung (32) des ersten Einheitsmoduls (30a) angeordnet wird, das über das zweite Einheitsmodul (30b) gestapelt ist.

9. Verfahren nach Anspruch 8, wobei für jedes Einheitsmodul (30) die Stützplattform (31) eine erste Seite (31a), welche die Aufstapelung (20) des Einheitsmoduls (30) trägt, und eine zweite Seite (31b) umfasst, die der ersten Seite (31a) entgegengesetzt ist, wobei die Gaseinlassöffnung (32) eine kegelstumpfförmige Form mit einem ersten Durchmesser (d1), der in der zweiten Seite (31b) der Stütze (31) gebildet ist, und einem zweiten Durchmesser (d2) umfasst, der kleiner ist als der erste Durchmesser (d1) und in der ersten Seite (31a) oder zwischen der ersten Seite (31a) und der zweiten Seite (31b) der Stützplattform (31) gebildet ist, und das zweite Ende (33b) des Injektionsrohrs (33) eine komplementäre kegelstumpfförmige Form umfasst, die mit der kegelstumpfförmigen Form einer Gaseinlassöffnung (32) zusammenwirkt.

10. Verfahren nach einem der Ansprüche 1 bis 9, umfassend ferner einen Schritt der Anordnung des Stapels von Einheitsmodulen (30) auf einem Ladungsträgerring (42), der in einer Vorheizzone (44) des Verdichtungsofens (40) angeordnet ist.

11. Verfahren nach einem der Ansprüche 1 bis 10, wobei jedes Einheitsmodul (30) einen ringförmigen Fuß (29) umfasst, der zwischen der Stützplattform (31) des Einheitsmoduls (30) und der Aufstapelung (20) von ringförmigen porösen Substraten (21) des Einheitsmoduls (30) angeordnet ist, wobei der ringförmige Fuß radiale Nuten beinhaltet, die gemäß einer Richtung (X) senkrecht zu der Richtung, in welcher die ringförmigen porösen Substrate gestapelt sind, zwischen einem zentralen Hohlraum des ringförmigen Fußes und der Außenseite des ringförmigen Fußes Durchgänge ausbilden.

12. Verfahren nach einem der Ansprüche 1 bis 11, wobei jedes ringförmige poröse Substrat (21) Kohlenstoff umfasst.

13. Verfahren nach einem der Ansprüche 1 bis 12, wobei jedes ringförmige poröse Substrat (21) eine Faservorform einer Bremsscheibe bildet.

## Claims

1. A method for densification by pressure gradient chemical vapor infiltration of porous annular substrates (21) having a central passage (21a), the method comprising at least the following steps:
- providing a plurality of stacks (20) of porous annular substrates (21), each stack (20) comprising an internal volume (24) formed by the central passages (21a) of the stacked substrates (21),
- providing a plurality of individual modules (30), each individual module (30) comprising a support plate (31) and a single stack (20) of porous annular substrates (21) disposed on the support plate (31), the support plate (31) comprising a gas inlet opening (32) and an injection tube (33) mounted on the gas inlet opening (32) and extending into the internal volume (24) of the stack (20) disposed on the support plate (31) between a first tube end (33a) connected to the support plate (31) and a second tube end (33b) which is free, the injection tube (33) further comprising gas injection orifices (34) opening into the internal volume (24),
- forming, in the chamber of a densification furnace (40), a stack of individual modules (30), each first individual module (30a) stacked on a second individual module (30b) having its gas inlet opening (32) of the support plate (31) communicating with the second end (33b) of the injection tube (33) of the second individual module (30b) on which it is stacked so as to permit circulation of a gas between the individual modules (30), and
- injecting into the internal volume (24) of each stack (20) of porous annular substrates (21) a gas phase comprising a gaseous precursor of a matrix material to be deposited within the porosities of the substrates (21),
**characterized in that,** in each individual module (30), each first porous annular substrate (21) is supported on a second porous annular substrate (21), or supported on the support plate (31), by means of a sealing ring (23) providing radial sealing between the first porous annular substrate (21) and the second porous annular substrate (21) or between the first porous annular substrate (21) and said support plate (31), and each sealing ring (23) is coupled to an annular spacer (22) having an inner diameter equal to an inner diameter of the porous annular substrates (21), each annular space (22) being surrounded by the sealing ring (23) with which it is associated in a plane perpendicular to the direction in which the porous annular substrates (21) are stacked, and having a thickness less than the thickness of the sealing ring (23) with which it is coupled.

2. The method according to claim 1, wherein each stack (20) comprises at least one cover disk (25) supported on the porous annular substrate (21) at the top of the stack (20) by means of a sealing ring (23) providing radial sealing between said cover disk (25) and said porous annular substrate (21) at the top of the stack (20).

3. The method according to claim 2, wherein each stack (20) further comprises a deformable annular seal (26) arranged to be compressed between the cover disk (25) and the support plate (31) of the upper individual module (30).

4. The method according to any one of claims 1 to 3, wherein, in each individual module (30), the sealing rings (23) are disposed at the radially outer periphery of the porous annular substrates (21).

5. The method according to any one of claims 1 to 3, wherein, in each individual module (30), the sealing rings (23) are alternately disposed, along the direction in which the porous annular substrates are stacked, at the radially outer periphery of the porous annular substrates (21) and at the radially inner periphery of the porous annular substrates (21).

6. The method according to any one of claims 1 to 5, wherein the sealing rings (23) are made of Inconel^{®}.

7. The method according to any one of claims 1 to 6, wherein each sealing ring (23) is welded to the annular spacer (22) to which it is coupled.

8. The method according to any one of claims 1 to 7, further comprising a seal alignment step of the individual modules (30) of the stack comprising, for each first individual module (30a) stacked on a second individual module (30b), insertion of the second end (33b) of the injection tube (33) of the second individual module (30b) into the gas inlet opening (32) of the first individual module (30a) stacked on said second individual module (30b), an annular seal (35) being disposed between the second end (33b) of the injection tube (33) of the second individual module (30b) and the gas inlet opening (32) of the first individual module (30a) stacked on said second individual module (30b).

9. The method according to claim 8, wherein, for each individual module (30), the support plate (31) comprises a first face (31a) supporting the stack (20) of the individual module (30) and a second face (31b) opposite the first face (31a), the gas inlet opening (32) comprises a frustoconical shape with a first diameter (d1) formed in the second face (31b) of the support (31) and a second diameter (d2) smaller than the first diameter (d1) and formed in the first face (31a) or between the first face (31a) and second face (31b) of the support plate (31), and the second end (33b) of the injection tube (33) comprises a complementary frustoconical shape cooperating with the frustoconical shape of the gas inlet opening (32).

10. The method according to any one of claims 1 to 9, further comprising a step of disposing the stack of individual modules (30) on a load-carrying shell (42) disposed on a preheating zone (44) of the densification furnace (40).

11. The method according to any one of claims 1 to 10, wherein each individual module (30) comprises an annular foot (29) disposed between the support plate (31) of the individual module (30) and the stack (20) of porous annular substrates (21) of the individual module (30), the annular foot having radial grooves forming passages, along a direction (X) orthogonal to the direction in which the porous annular substrates are stacked between a central cavity of the annular foot and the outside of the annular foot.

12. The method according to any one of claims 1 to 11, wherein each porous annular substrate (21) comprises carbon.

13. The method according to any one of claims 1 to 12, wherein each porous annular substrate (21) constitutes a fibrous brake disc preform.
